# EUROPEAN PATENT APPLICATION

(11) **EP 4 629 295 A1**
(43) Date of publication of application: **08.10.2025**
(21) Application number: 23914429.8
(22) Date of filing: 24.11.2023
(51) Int. Cl.: H01L 31/18, H01L 31/0236, H01L 31/0352

(54) **PREPARATION METHOD FOR BACK CONTACT SOLAR CELL, AND BACK CONTACT SOLAR CELL**

(30) Priority: 06.01.2023 CN 202310016443
(71) Applicant: Ja Solar Technology Yangzhou Co., Ltd., Yangzhou, Jiangsu 225131 (CN)
(72) Inventor: HUANG, Zhuo, Yangzhou, Jiangsu 225131 (CN); CHEN, Bin, Yangzhou, Jiangsu 225131 (CN); WANG, Yulin, Yangzhou, Jiangsu 225131 (CN)
(74) Representative: Sun, Yiming
(86) International application number: PCT/CN2023/134032
(87) International publication number: WO 2024/146295

(57) **Abstract**

The present disclosure discloses a preparation method for a back contact solar cell and a back contact solar cell. The preparation method comprises: performing double-sided polishing treatment on a silicon substrate; stacking and forming a first tunneling oxide layer, a P+ polysilicon layer and a laser blocking layer on a back side of the silicon substrate from inside to outside, wherein a first silicon oxide layer is synchronously formed on the P+ polysilicon layer; removing the laser blocking layer and the first silicon oxide layer in a first region by laser, wherein the first region and a second region retaining the laser blocking layer are arranged alternately; removing the first tunneling oxide layer and the P+ polysilicon layer in the first region; controlling, in the first region, the formation of a second tunneling oxide layer and an N+ polysilicon layer stacked on the second tunneling oxide layer, which are isolated from and alternately arranged with the first tunneling oxide layer and the P+ polysilicon layer, and performing texturing treatment on a gap region in the first region adjacent to the second region and on a front side of the silicon substrate; removing the laser blocking layer and the first silicon oxide layer in the second region by acid cleaning, thereby improving the stability of the preparation process of a back contact solar cell.

## Description

### Cross Reference to Related Applications

The application claims priority to CN Patent Application No. 202310016443.9, which was filed on January 6, 2023, and the contents of which are hereby incorporated by reference in its entirety.

### Technical Field

The present disclosure relates to a preparation method for a back contact solar cell, and a back contact solar cell.

### Background Art

The existing preparation process for a back contact solar cell with the introduction of a passivated contact structure is relatively complicated. Moreover, after a P+ doped polysilicon layer is formed on a passivation layer, a mask layer is prepared by removing part of the P+ doped polysilicon layer in a direct laser ablation manner or introducing photoresist, ink or the like into the P+ doped polysilicon layer, and part of the mask layer is removed by photolithography, laser, chemical corrosion, etc.; in the subsequent process, the P+ doped polysilicon layer which is not covered by the mask layer is removed by chemical cleaning technology, then an N+ doped polysilicon layer is formed in a region where the P+ doped polysilicon layer is removed, and subsequently the mask layer is further removed. In the existing preparation process for a back contact solar cell with the introduction of a passivated contact structure, it is difficult to accurately control the removal of nanometer-thick film layers in such manners as photolithography, laser and chemical corrosion, which inevitably causes damage to a passivation layer corresponding to the N+ doped polysilicon layer, and as a result, the stability of the preparation process for a back contact solar cells is relatively poor, the photoelectric conversion efficiencies of the prepared back contact solar cells are still not ideal, and the photoelectric conversion efficiencies between the prepared back contact solar cells are greatly different.

### Summary of the Invention

In view of this, the present disclosure provides a preparation method for a back contact solar cell and a back contact solar cell. The preparation method can effectively improve the stability of the preparation process for a back-contact solar cell and can maintain consistency in the photoelectric conversion efficiencies between the prepared back contact solar cells.

The present disclosure provides the following technical solutions:
According to a first aspect of the present disclosure, the present disclosure provides a preparation method for a back contact solar cell, comprising:
step a: performing double-sided polishing treatment on a silicon substrate;
step b: stacking and forming a first tunneling oxide layer, a P+ polysilicon layer and a laser blocking layer on a back side of the silicon substrate from inside to outside, wherein in a process of forming the P+ polysilicon layer, a first silicon oxide layer is synchronously formed on the P+ polysilicon layer;
step c: removing the laser blocking layer and the first silicon oxide layer in a first region on the back side of the silicon substrate by laser, wherein the first region and a second region retaining the laser blocking layer and the first silicon oxide layer are arranged alternately;
step d: removing the first tunneling oxide layer and the P+ polysilicon layer in the first region by alkaline solution polishing;
step e: controlling, in the first region on the back side of the silicon substrate, the formation of a second tunneling oxide layer and an N+ polysilicon layer stacked on the second tunneling oxide layer, which are isolated from and alternately arranged with the first tunneling oxide layer and the P+ polysilicon layer, and synchronously performing texturing treatment on a gap region in the first region adjacent to the second region and a front side of the silicon substrate so as to form a texture structure on the gap region and the front side of the silicon substrate, wherein the gap region is used to isolate the P+ polysilicon layer and the N+ polysilicon layer which are adjacent;
step f: removing the laser blocking layer and the first silicon oxide layer on the second region by acid cleaning.

According to a second aspect of the present disclosure, an embodiment of the present disclosure provides a back contact solar cell prepared in the embodiment of the above first aspect, comprising:
a silicon substrate;
a first tunneling oxide layer and a second tunneling oxide layer which are formed on a back side of the silicon substrate, isolated from each other and arranged alternately;
a P+ polysilicon layer stacked on the first tunneling oxide layer;
an N+ polysilicon layer stacked on the second tunneling oxide layer;
a gap region which is formed on the back side of the silicon substrate and used to isolate the first tunneling oxide layer and the second tunneling oxide layer which are adjacent and the P+ polysilicon layer and N+ polysilicon layer which are adjacent;
regions on the back side of the silicon substrate corresponding to the first tunneling oxide layer and the second tunneling oxide layer are polished surfaces;
the front side of the silicon substrate and the gap region are provided with texture structures which are synchronously formed, wherein the texture structures are synchronously formed in a process of controlling the formation of the second tunneling oxide layer and the N+ polysilicon layer which are isolated from and alternately arranged with the first tunneling oxide layer and the P+ polysilicon layer.

The above technical solution in the first aspect of the invention has the following advantages or beneficial effects:
1. By arranging a laser blocking layer on a P+ polysilicon layer, the preparation method for a back contact solar cell provided by the present invention can cause the laser blocking layer to absorb laser energy and block the transfer of laser energy in a process of removing the laser blocking layer and the first silicon oxide layer in the first region on the back side of the silicon substrate by laser. Moreover, after removing the laser blocking layer in the first region on the back side of the silicon substrate by laser, due to the presence of a step of removing the first tunneling oxide layer and the P+ polysilicon layer in the first region by alkaline solution polishing and the presence of a step of controlling, in the first region on the back side of the silicon substrate, the formation of a second tunneling oxide layer and an N+ polysilicon layer stacked on the second tunneling oxide layer, which are isolated from and alternately arranged with the first tunneling oxide layer and the P+ polysilicon layer, i.e., a step of re-forming a second tunneling oxide layer below the N+ polysilicon layer after the laser treatment, the preparation method for a back contact solar cell provided by the present invention can control the width of the first region more accurately by causing the laser to have a wider use window and removing the laser blocking layer and the first silicon oxide layer in the first region on the back side of the silicon substrate by laser without considering the damage of the laser to the first tunneling oxide layer and the P+ polysilicon layer in the process of laser treatment.
2. Based on the above fact that the damage of the laser to the first tunneling oxide layer and the P+ polysilicon layer in the first region does not need to be considered in the process of causing the laser to have a wider use window and removing the laser blocking layer in the first region, the laser blocking layer in the second region is subsequently removed by acid cleaning so that the laser blocking layer will not remain in the final cell structure. Therefore, the arrangement of the laser blocking layer and the thickness of the laser blocking layer would not have any influence on the back contact solar cell. On this basis, the thickness of the laser blocking layer can be adjusted according to requirements, so that the preparation process of the back contact solar cell has better process flexibility and a better process operation window.
3. Due to the presence of a step of removing the first tunneling oxide layer and the P+ polysilicon layer in the first region by alkaline solution polishing and the presence of a step of controlling, in the first region on the back side of the silicon substrate, the formation of a second tunneling oxide layer and an N+ polysilicon layer stacked on the second tunneling oxide layer, which are isolated from and alternately arranged with the first tunneling oxide layer and the P+ polysilicon layer, i.e., a step of re-forming a second tunneling oxide layer below the N+ polysilicon layer after the laser treatment, then, even if the laser causes damage to a tunneling oxide layer corresponding to the N+ polysilicon layer under a wider laser use window, it will not affect the photoelectric conversion performance of the back contact solar cell, which improves the stability of the preparation process of the back contact solar cell and can thereby effectively improve the relative consistency in the photoelectric conversion efficiencies between the prepared back contact solar cells.
4. Removing the first tunneling oxide layer and the P+ polysilicon layer in the first region by alkaline solution polishing can avoid residual P+ doped elements in the first region, thereby reducing carrier recombination in the first region and effectively improving the photoelectric conversion efficiency of the back contact solar cell.
5. Through polishing treatment, both the region where the first tunneling oxide layer is formed and the region where the second tunneling oxide layer is formed are polished surfaces, so as to ensure the flatness and uniformity of the first tunneling oxide layer, the second tunneling oxide layer, the P+ polysilicon layer and the N+ polysilicon layer and effectively improve the passivation effect and photoelectric conversion efficiency of the back contact solar cell.
6. Texturing of the gap region and the front side is completed in the process of removing the N+ polysilicon and the second silicon oxide layer in the second region and the gap region, so that both the gap region and the front side of a prepared back contact solar cell are texture structures, which simplifies the preparation process and thereby ensures the light utilization rate of the back contact solar cell.

### Brief Description of the Drawings

FIG. 1 is a schematic diagram of the main process of a preparation method for a back contact solar cell, as provided according to an embodiment of the present disclosure;
FIG. 2 is a schematic view of a partial cross-sectional structure in a preparation process of a back contact solar cell, as provided according to an embodiment of the present disclosure;
FIG. 3 is a schematic view of a partial cross-sectional structure obtained after the treatment in step S13, as provided according to an embodiment of the present disclosure;
FIG. 4 is a schematic view of a partial cross-sectional structure obtained after the treatment in step S14, as provided according to an embodiment of the present disclosure;
FIG. 5 is a schematic diagram of the main process of implementing step S15, as provided according to an embodiment of the present disclosure;
FIG. 6 is a schematic view of a partial cross-sectional structure in which a plurality of film layers are synchronously formed correspondingly on a front side of the silicon substrate in step S151, as provided according to an embodiment of the present disclosure;
FIG. 7 is a schematic cross-sectional view of a structure obtained by removing a film layer on the front side of a silicon substrate corresponding to the second silicon oxide layer, as provided according to an embodiment of the present disclosure;
FIG. 8 is a schematic view of a partial cross-sectional structure obtained after the treatment in step S152, as provided according to an embodiment of the present disclosure;
FIG. 9 is a schematic view of a partial cross-sectional structure obtained after the treatment in step S153, as provided according to an embodiment of the present disclosure;
FIG. 10 is a schematic view of a partial cross-sectional structure obtained by synchronously removing the second silicon oxide layer on the N+ polysilicon layer for the structure shown in FIG. 9, as provided according to an embodiment of the present disclosure;
FIG. 11 is a bottom view of a back contact solar cell of FIG. 10, as provided according to an embodiment of the present disclosure;
FIG. 12 is a schematic cross-sectional view of a back contact solar cell comprising passivation anti-reflection layers, as provided according to an embodiment of the present disclosure;
FIG. 13 is a schematic cross-sectional view of a back contact solar cell after electrodes are formed, as provided according to an embodiment of the present disclosure.

### Reference signs are as follows:

1-silicon substrate; 2-first tunneling oxide layer; 2'-first film layer; 3-P+ polysilicon layer; 3'-second film layer; 31-first silicon oxide layer; 31'-third film layer; 4-laser blocking layer; 4'-fourth film layer; 5-second tunneling oxide layer; 5'-fifth film layer; 6-N+ polysilicon layer; 6'-sixth film layer; 61-second silicon oxide layer; 61'-seventh film layer; 7-gap region; 8-back passivation anti-reflection layer; 9-front passivation anti-reflection layer; 101-first electrode; 102-second electrode.

### Detailed Description of Embodiments

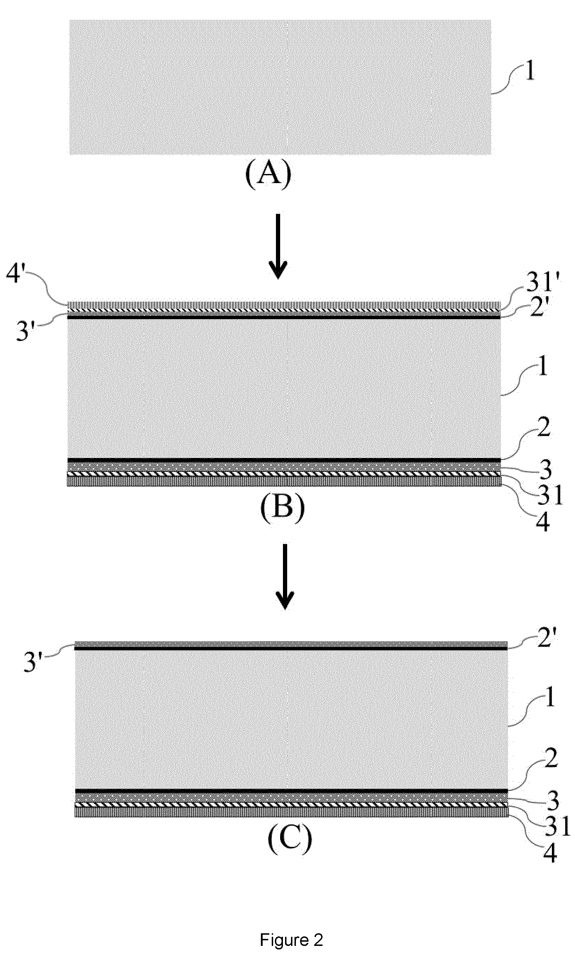

Stacking a plurality of other structures from inside to outside at a particular position of a structure (such as a back side, a front side, a lateral side, a partial region of a back side, a partial region of the front side, etc.) as involved in the embodiments of the present disclosure means stacking, with the structure as a starting point, a plurality of other structures in a direction away from the structure. For example, as shown in FIGs 2 to 8 and other figures, stacking a first tunneling oxide layer 2, a P+ polysilicon layer 3, a first silicon oxide layer 31 and a laser blocking layer 4 on the back side of the silicon substrate 1 in a sequence from inside to outside is providing, with the back side of the silicon substrate 1 as a starting point, the first tunneling oxide layer 2, the P+ polysilicon layer 3, the first silicon oxide layer 31 and the laser blocking layer 4 sequentially in a direction away from the back side of the silicon substrate 1, wherein the first tunneling oxide layer 2 is in direct contact with the silicon substrate 1, i.e., the first tunneling oxide layer 2 is closest to the back side of the silicon substrate 1, the P+ polysilicon layer 3 is stacked on the first tunneling oxide layer 2, the first silicon oxide layer 31 is stacked on the P+ polysilicon layer 3, and the laser blocking layer 4 is stacked on the first silicon oxide layer 31.

Stacking/forming another structure on a structure as involved in the embodiments of the present disclosure does not specifically mean that another structure is located above the structure, and it generally means that another structure is stacked/formed on part or all of the main surface of the structure away from the silicon substrate and another structure is in direct or indirect contact with part or all of the main surface of the structure away from the silicon substrate

The front side of a structure as involved in the embodiments of the present disclosure generally refers to a main surface, which faces towards the sunlight, of the structure as a portion of the back contact solar cell when the back contact solar cell is in use. Accordingly, the back side of a structure generally refers to a main surface, which faces away from the sunlight, of the structure as a portion of the back contact solar cell when the back contact solar cell is in use. For example, the back side and the front side of the silicon substrate respectively refer to two main surfaces of the P-type silicon substrate, which are arranged opposite to each other, have relatively large areas, and are used as a backlight side (a side facing away from the sunlight) and a light-receiving side (a side facing towards the sunlight) of the solar cell.

When one structure penetrates another structure as involved in the embodiments of the present disclosure, it means that one portion of the one structure passes from one side of the another structure to the other side of the another structure in a thickness direction of the another structure. For example, a second electrode that penetrates the front passivation anti-reflection layer means that the second electrode passes from one side of the front passivation anti-reflection layer to the other side of the front passivation anti-reflection layer. For another example, a first electrode that penetrates the back passivation anti-reflection layer means that the first electrode passes from one side of the back passivation anti-reflection layer to the other side of the back passivation anti-reflection layer.

The synchronization of one treatment process and another treatment process as involved in the embodiments of the present disclosure generally means that the one treatment process and the another treatment process are completed through a one-step operation in the same step or are treated through the same solution in the same step. For example, synchronously performing texturing treatments on a gap region 7 in the first region adjacent to the second region and on a front side of the silicon substrate 1 refers to texturizing the gap region 7 and the front side of the silicon substrate 1 through the same alkaline solution. For another example, during the acid cleaning in step f, synchronously removing the second silicon oxide layer on the N+ polysilicon layer in the first region means that removing the second silicon oxide layer on the N+ polysilicon layer in the first region is also completed by the acid cleaning in step f.

The "first" and "second" as involved in the embodiments of the present disclosure are only for distinguishing between different positions, or the contacted structures, or the realized functions, but are not intended to limit the number or sequence of structures as for structures made of the same material, such as a first tunneling oxide passivation layer and a second tunneling oxide passivation layer, a first electrode and a second electrode, etc.

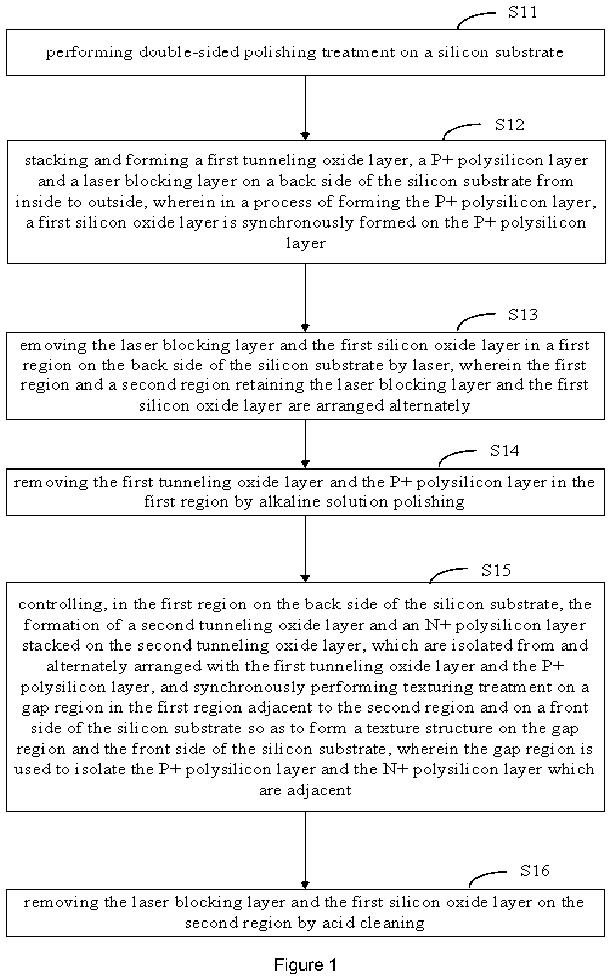

In order to solve the problems about complicated preparation process, poor process stability, large differences in the prepared back-contact solar cells, carrier recombination on the surface of a silicon substrate, and difficulty in further improving the photoelectric conversion efficiency of the prepared back-contact solar cells existing in the existing preparation method for a back contact solar cell, the embodiments of the present disclosure provide a preparation method for a back contact solar cell, wherein FIG. 1 shows a schematic diagram of the main process of a preparation method for a back contact solar cell, and FIGs. 2-4 and 6-13 show schematic diagrams of partial structures on which the respective procedures included in the preparation method depend or partial structures obtained by the respective procedures. As shown in FIG. 1, the preparation method for a back contact solar cell may comprise the following steps:
step S11: performing double-sided polishing treatment on a silicon substrate 1;
step S12: stacking and forming a first tunneling oxide layer 2, a P+ polysilicon layer 3 and a laser blocking layer 4 on a back side of the silicon substrate 1 from inside to outside, wherein in a process of forming the P+ polysilicon layer 3, a first silicon oxide layer 31 is synchronously formed on the P+ polysilicon layer 3;
step S13: removing the laser blocking layer 4 and the first silicon oxide layer 31 in a first region on the back side of the silicon substrate 1 by laser, wherein the first region and a second region retaining the laser blocking layer 4 and the first silicon oxide layer 31 are arranged alternately;
step S14: removing the first tunneling oxide layer 2 and the P+ polysilicon layer 3 in the first region by alkaline solution polishing;
step S15: controlling, in the first region on the back side of the silicon substrate 1, the formation of a second tunneling oxide layer 5 and an N+ polysilicon layer stacked on the second tunneling oxide layer 5, which are isolated from and alternately arranged with the first tunneling oxide layer 2 and the P+ polysilicon layer 3, and synchronously performing texturing treatment on a gap region 7 in the first region adjacent to the second region and on a front side of the silicon substrate 1 so as to form a texture structure on the gap region 7 and the front side of the silicon substrate, wherein the gap region 7 is used to isolate the P+ polysilicon layer 3 and the N+ polysilicon layer 6 which are adjacent;
step S16: removing the laser blocking layer 4 and the first silicon oxide layer 31 on the second region by acid cleaning.

The silicon substrate used in the above steps may be a P-type silicon substrate or an N-type silicon substrate.

As for the above step S11, it mainly refers to performing polishing treatment on two main surfaces of the silicon substrate to achieve flatness of the two main surfaces of the silicon substrate, wherein the polishing treatment on the two main surfaces of the silicon substrate can be achieved by using existing polishing techniques (details are omitted herein). In addition, compared with single-sided polishing treatment, double-sided polishing treatment reduces the requirements on the process control accuracy, making it easier to control this step. Further, through the polishing treatment in step S11, regions in contact with the tunneling oxide layers (the first tunneling oxide layer and the second tunneling oxide layer) on the silicon substrate can be ensured to be flat in the subsequent processing steps, so as to effectively improve the flatness and uniformity of the tunneling oxide layers (the first tunneling oxide layer and the second tunneling oxide layer) prepared in the subsequent steps and the P+ polysilicon layer and the N+ polysilicon layer stacked on the tunneling oxide layers, thereby effectively improving the passivation effect of the passivated contact structure formed on the back side of the back contact solar cell.

Moreover, in the above step S12, the first tunneling oxide layer 2, the P+ polysilicon layer 3 and the laser blocking layer 4 can be formed by one or more deposition methods selected from Low-Pressure Chemical Vapor Deposition (LPCVD), Plasma Enhanced Chemical Vapor Deposition (PECVD), Physical Vapor Deposition (PVD) and Atomic Layer Deposition (ALD), wherein the first tunneling oxide layer 2 prepared through deposition is generally silicon oxide and may have a thickness of 0.5-3.0 nm, and wherein the P+ polysilicon layer 3 is generally formed in a process as follows: firstly depositing an intrinsic amorphous silicon layer or a microcrystalline silicon layer on the first tunneling oxide layer 2, then doping the intrinsic amorphous silicon layer or the microcrystalline silicon layer with a boron element, converting the intrinsic amorphous silicon layer or the microcrystalline silicon layer into a polysilicon layer through a process such as high temperature annealing, and activating the doped boron element.

Further, in the step S12, in the process of forming the P+ polysilicon layer 3, a first silicon oxide layer 31 can be synchronously formed on the P+ polysilicon layer 3. The first silicon oxide layer 31 may include silicon oxide or boron-containing silicon oxide, and it is generally formed through a reaction between the silicon on the surface with oxygen in the reaction environment in the process of converting an intrinsic amorphous silicon layer or a microcrystalline silicon layer into a polysilicon layer or in the process of doping a boron element. In other words, the process of forming the P+ polysilicon layer 3 can be completed in an atmospheric environment without needing to be performed in an inert atmosphere, thereby reducing the condition control and the cost of depositing the P+ polysilicon layer 3. In addition, the first silicon oxide layer 31 and the laser blocking layer 4 can jointly block the laser from damaging the first tunneling oxide layer 2 and the P+ polysilicon layer 3 in the second region, and meanwhile, the laser blocking layer 4 absorbs laser energy and blocks the transfer of laser energy.

The laser blocking layer 4 may be deposited from at least one material of silicon oxide, silicon nitride oxide and silicon nitride. The materials used to prepare the laser blocking layer 4 are materials commonly used in a process of preparing a solar cell, and would not increase the cost of a back contact solar cell.

Specifically, as for the step S12, in order to further reduce the complexities, restrictions and the like of the process and ensure the stability of the preparation process while reducing the cost of the preparation process, a plurality of film layers are synchronously formed correspondingly on a front side of the silicon substrate 1 in the process of forming the first tunneling oxide layer 2, the P+ polysilicon layer 3, the first silicon oxide layer 31 and the laser blocking layer 4. As shown in FIG. 2, through the step S12, the first tunneling oxide layer 2, the P+ polysilicon layer 3, the first silicon oxide layer 31 and the laser blocking layer 4 are sequentially stacked and deposited on the back side of the silicon substrate 1 from inside to outside as shown in FIG. 2(A), and meanwhile, a first film layer 2' corresponding to the first tunneling oxide layer 2 is deposited on the front side of the silicon substrate 1 in the process of depositing the first tunneling oxide layer 2, a second film layer 3' corresponding to the P+ polysilicon layer 3 and a third film layer 31' corresponding to the first silicon oxide layer 31 and stacked on the second film layer 3' are formed on the first film layer 2' in the process of forming the P+ polysilicon layer 3, and a fourth film layer 4' corresponding to the laser blocking layer 4 is formed on the third film layer 31' in the process of depositing the laser blocking layer 4, thereby obtaining the structure shown in FIG. 2(B). As for the circumstance where a plurality of film layers are synchronously formed on the front side of the silicon substrate 1 in the step S12 as shown in FIG. 2, after the above step S12, the preparation method may further comprise: removing the film layers on the front side of the silicon substrate 1 corresponding to the first silicon oxide layer 31 and the laser blocking layer 4 by acid etching or laser, i.e., removing the fourth film layer 4' and the third film layer 31' in the structure shown in FIG2 (B) by this step to obtain the structure shown in FIG2 (C). It is worth noting that the step of removing the film layers on the front side of the silicon substrate 1 corresponding to the first silicon oxide layer 31 and the laser blocking layer 4 by acid etching or laser can be performed before or after the above step S13. In a preferred embodiment, the step of removing the film layers on the front side of the silicon substrate 1 corresponding to the first silicon oxide layer 31 and the laser blocking layer 4 by acid etching or laser is performed before the above step S13 so as to reduce the influences of this step on the back side of the silicon substrate 1, wherein the acid selected for acid etching in this step can be some acids such as hydrofluoric acid for corroding film layers as used in a production process of a back contact solar cell, and the intensity of the selected laser can be adjusted according to the thickness of the film layers, and limitations are not made herein.

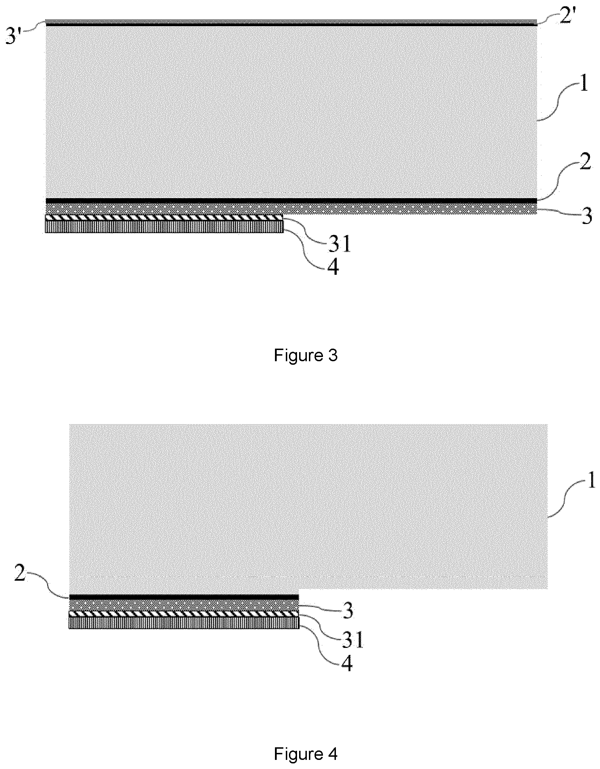

Further, taking the structure shown in FIG. 2(C) as an example, after the treatment in the above step S13, the structure shown in FIG. 3 can be obtained. It is worth noting that the widths of the first region and the second region as shown in FIG. 3 can be accordingly set according to actual requirements. The width of the first region can be controlled by adjusting the width of the laser. Understandably, the laser blocking layer 4 and the first silicon oxide layer 31 are materials which can be removed by laser, but they can serve as absorption layers of laser energy due to their certain thicknesses and block the laser from reaching the first tunneling oxide layer 2 and the P+ polysilicon layer 3 within a certain period of time. In addition, after removing the laser blocking layer in the first region on the back side of the silicon substrate by laser, due to the presence of a step of removing the first tunneling oxide layer and the P+ polysilicon layer in the first region by alkaline solution polishing and the presence of a step of controlling, in the first region on the back side of the silicon substrate, the formation of a second tunneling oxide layer and an N+ polysilicon layer stacked on the second tunneling oxide layer, which are isolated from and alternately arranged with the first tunneling oxide layer and the P+ polysilicon layer, i.e., a step of re-forming a second tunneling oxide layer below the N+ polysilicon layer after the laser treatment, the width of the first region can be controlled more accurately by causing the laser to have a wider use window and removing the laser blocking layer and the first silicon oxide layer in the first region on the back side of the silicon substrate by laser without considering the damage of the laser to the first tunneling oxide layer and the P+ polysilicon layer in the process of laser treatment of step 13.

In addition, the laser blocking layer can absorb the laser energy transferred to the first region, and thereby block thermal damage caused by the laser acting on the first region.

Further, based on the above fact that the damage of the laser to the first tunneling oxide layer and the P+ polysilicon layer in the first region does not need to be considered in the process of causing the laser to have a wider use window and removing the laser blocking layer in the first region, the laser blocking layer in the second region is subsequently removed by acid cleaning so that the laser blocking layer will not remain in the final cell structure. Therefore, both the arrangement of the laser blocking layer and the thickness of the laser blocking layer would not have any influence on the back contact solar cell. On this basis, the thickness of the laser blocking layer can be adjusted according to requirements, so that the preparation process of the back contact solar cell has better process flexibility and a better process operation window, thereby further improving the controllability of the above step S13 and the stability of the preparation process of the back contact solar cell. Moreover, in step S13, through the setting of the width of the laser in combination with the use of the laser blocking layer, a gap region between the P region and the N region can be effectively formed and the partitioning of the P and N regions can be completed without needing to separately manufacture the spacer, which further simplifies the process flow.

Further, in the above step S14, the film layers on the front side of the silicon substrate 1 corresponding to the first tunneling oxide layer 2 and the P+ polysilicon layer 3 can be removed synchronously by alkaline solution polishing. Taking the structure shown in FIG. 3 as an example, the first tunneling oxide layer 2 and the P+ polysilicon layer 3 in the first region as shown in FIG. 3 can be removed through the step S14, and the second film layer 3' corresponding to the P+ polysilicon layer 3 and the first film layer 2' corresponding to the first tunneling oxide layer 2 on the front side of the silicon substrate 1 can be removed synchronously to obtain the structure shown in FIG. 4. The alkaline solution may be selected from an alkaline solution commonly used in an existing preparation process of a solar cell, and the parameters such as the concentration of the alkaline solution may be accordingly adjusted according to requirements. In addition, by the alkaline solution polishing process in the above step S14, part of the silicon substrate corresponding to the first region on the back side of the silicon substrate can be also removed, and the thickness of the silicon substrate in the first region can be made smaller than that in the second region, as shown in FIG. 4. By removing part of the silicon substrate corresponding to the first region, it is possible to effectively remove the boron element that enters the silicon substrate of the first region in the process of forming the P+ polysilicon layer 3 in the step S12 and reduce carrier recombination in the first region. In addition, since the step 14 can effectively remove the boron element that enters the silicon substrate in the first region and reduce the carrier recombination in the first region, the conditions for forming the P+ polysilicon layer 3 in the step S12 can be further relaxed so as to better ensure the stability of the entire process.

In addition, since the re-forming of the second tunneling oxide layer located below the N+ polysilicon layer is achieved due to a combination of the above steps S14 and S15, then the laser will not affect the photoelectric conversion performance of the back contact solar cell even if the laser causes damage to the tunneling oxide layer corresponding to the N+ doped polysilicon layer under a wider laser use window, which improves the stability of the preparation process of the back contact solar cell, and thereby effectively improves the relative consistency in the photoelectric conversion efficiencies between the prepared back contact solar cells.

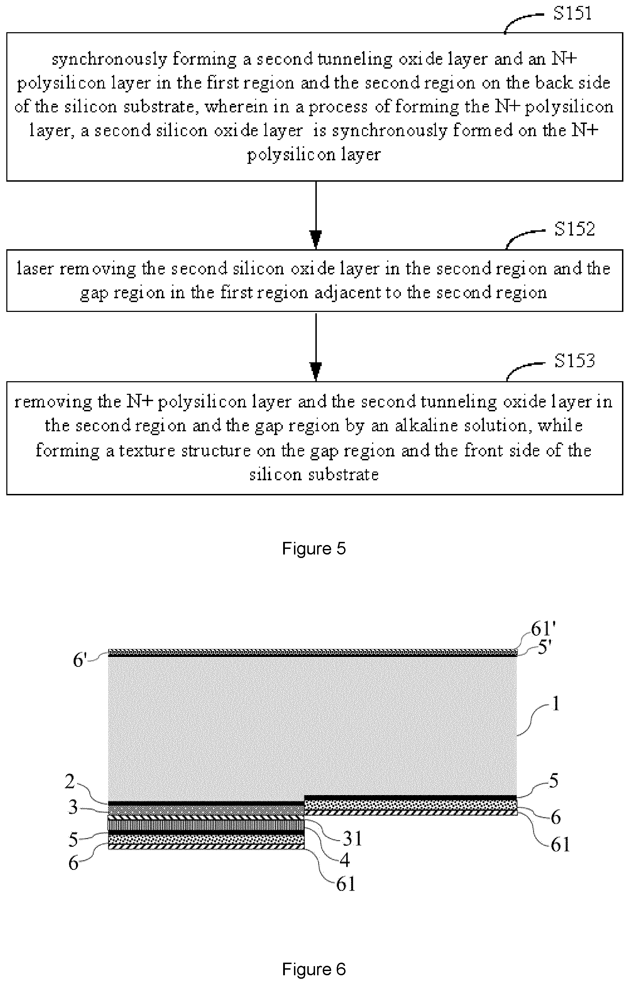

More specifically, in the embodiments of the present disclosure, as shown in FIG. 5, the implementation of the above step S15 may include the following process steps:
Step S151: synchronously forming a second tunneling oxide layer 5 and an N+ polysilicon layer 6 in the first region and the second region on the back side of the silicon substrate 1, wherein in a process of forming the N+ polysilicon layer 6, a second silicon oxide layer 61 is synchronously formed on the N+ polysilicon layer 6.

In this step, by synchronously forming the second silicon oxide layer 61 on the N+ polysilicon layer 6 in the process of forming the N+ polysilicon layer 6, the process of forming the N+ polysilicon layer 6 can be completed in the atmospheric environment without introducing an inert atmosphere. In addition, in order to further reduce the condition restrictions of this step, a plurality of film layers can be synchronously formed correspondingly on the front side of the silicon substrate 1 in the process of forming the second tunneling oxide layer 5, the N+ polysilicon layer 6 and the second silicon oxide layer 61. Taking the structure shown in FIG. 4 as an example, the structure shown in FIG. 6 can be obtained through this step. As shown in FIG. 6, the second tunneling oxide layer 5, the N+ polysilicon layer 6 and the second silicon oxide layer 61 which are stacked are formed in both the first region and the second region on the back side of the silicon substrate 1, wherein the second tunneling oxide layer 5 located in the first region is in direct contact with the back side of the silicon substrate, and the second tunneling oxide layer 5 located in the second region is in direct contact with the laser blocking layer 4 in the second region. In addition, as shown in FIG. 6, a fifth film layer 5' corresponding to the second tunneling oxide layer 5, a sixth film layer 6' stacked on the fifth film layer 5' and corresponding to the N+ polysilicon layer 6, and a seventh film layer 61' stacked on the sixth film layer 6' and corresponding to the second silicon oxide layer 61 are formed on a front side of the silicon substrate 1, wherein the second silicon oxide layer may include silicon oxide or phosphorus-containing silicon oxide.

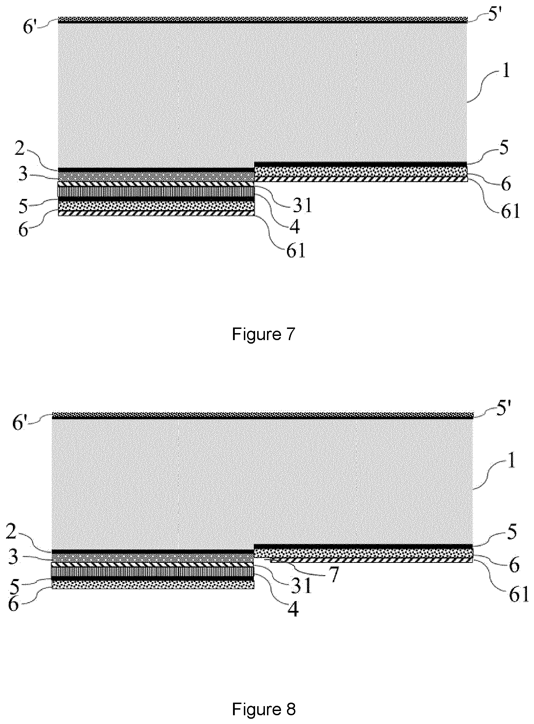

Furthermore, as for forming a plurality of film layers on the front side of the silicon substrate 1 corresponding to the second tunneling oxide layer 5, the N+ polysilicon layer 6 and the second silicon oxide layer 61 as shown in FIG. 6, after this step S151, the preparation method may further comprise: removing the film layer on the front side of the silicon substrate 1 corresponding to the second silicon oxide layer 61 by acid etching or laser, as shown in FIG. 7. Compared with FIG. 6, the seventh film layer 61' corresponding to the second silicon oxide layer 61 is removed by this step. The process of removing the film layer on the front side of the silicon substrate 1 corresponding to the second silicon oxide layer 61 can be performed before or after the step S152. In a preferred embodiment, the process of removing the film layer on the front side of the silicon substrate 1 corresponding to the second silicon oxide layer 61 can be performed before the step S152. In an acid etching selecting process, acids such as hydrofluoric acid for corroding silicon oxide as commonly used in a preparation process of a solar cell can be selected, wherein the parameters such as the concentration and action time of the acids can be adjusted according to requirements. In a laser selecting process, the parameters such as the intensity of the laser can be adjusted according to requirements, and limitations are not made herein.

The second tunneling oxide layer 5 and the N+ polysilicon layer 6 in this step can be prepared by one or more deposition methods selected from Low-Pressure Chemical Vapor Deposition (LPCVD), Plasma Enhanced Chemical Vapor Deposition (PECVD), Physical Vapor Deposition (PVD) and Atomic Layer Deposition (ALD). The prepared second tunnel oxide layer 5 is generally silicon oxide and may have a thickness of 0.5-3.0 nm.

Step S152: laser removing the second silicon oxide layer 61 in the second region and the gap region 7 in the first region adjacent to the second region;
Taking the structure shown in FIG. 7 as an example, through the step S152, a structure after the second silicon oxide layers 61 in the second region and the gap region 7 in the first region adjacent to the second region are removed as shown in FIG. 8 can be obtained through this step S152.

During removing the second silicon oxide layers in the second region and the gap region by laser in the step S152, the laser blocking layer exists in the second region due to the treatment in the previous steps. The laser blocking layer can absorb laser energy to prevent the laser energy from being transferred to the P+ polysilicon layer and the first tunneling oxide layer that need to be retained in the back contact solar cell, so as to prevent the laser treatment in this step from destroying or damaging the P+ polysilicon layer and the first tunneling oxide layer in the second region, thereby ensuring the integrity of the P+ polysilicon layer and the first tunneling oxide layer of the back contact solar cell and the performance of the cell, while contributing to the stability of the preparation process.

In this step, laser is selected to remove the second silicon oxide layers 61 in the second region and the gap region 7 in the first region adjacent to the second region, so as to facilitate the completion of the subsequent step S153. At the same time, compared with other manners of removing the second silicon oxide layer 61 by masking, the laser removing effectively simplifies the process operations.

Moreover, in this step, the width of the gap region 7 or the spacing between the P+ polysilicon layer 3 and the N+ polysilicon layer 6 which are adjacent can be controlled to be 1×10³ nm to 5×10⁵ nm, wherein the spacing between the P+ polysilicon layer 3 and the N+ polysilicon layer 6 which are adjacent refers to a distance between a side of the P+ polysilicon layer 3 close to the N+ polysilicon layer 6 and a side of the N+ polysilicon layer 6 close to the P+ polysilicon layer 3. By controlling the width of the gap region 7 or the spacing between the P+ polysilicon layer 3 and the N+ polysilicon layer 6 which are adjacent to any value between 1×10³ nm and 5×10⁵ nm, such as 2×10³ nm, 3×10³ nm, 5×10³ nm, 1×10⁴ nm, 3×10⁴ nm, 5×10⁴ nm, 7×10⁴ nm, 9×10⁴ nm, 1×10⁵ nm, 2×10⁵ nm, 4×10⁵ nm, 5×10⁵ nm, etc., it is possible to ensure the P+ polysilicon layer 3 and the N+ polysilicon layer 6 while effectively reducing carrier recombination.

Step S153: removing the N+ polysilicon layer 6 and the second tunneling oxide layer 5 in the second region and the gap region 7 by an alkaline solution, while synchronously removing the film layers on the front side of the silicon substrate 1 corresponding to the second tunneling oxide layer 5 and the N+ polysilicon layer 6 and forming a texture structure on the gap region 7 and the front side of the silicon substrate 1.

In other words, through one alkaline solution treatment, not only the N+ polysilicon layer 6 and the second tunneling oxide layer 5 in the second region and the gap region 7 as well as the film layers on the front side of the silicon substrate 1 corresponding to the second tunneling oxide layer 5 and the N+ polysilicon layer 6 can be removed, but also a texture structure can be formed on the gap region and the front side of the silicon substrate 1, wherein the texture structure on the gap region 7 and the texture structure on the front side of the silicon substrate 1 can be completed synchronously, which simplifies the preparation process and thereby ensures the light utilization rate of the cell.

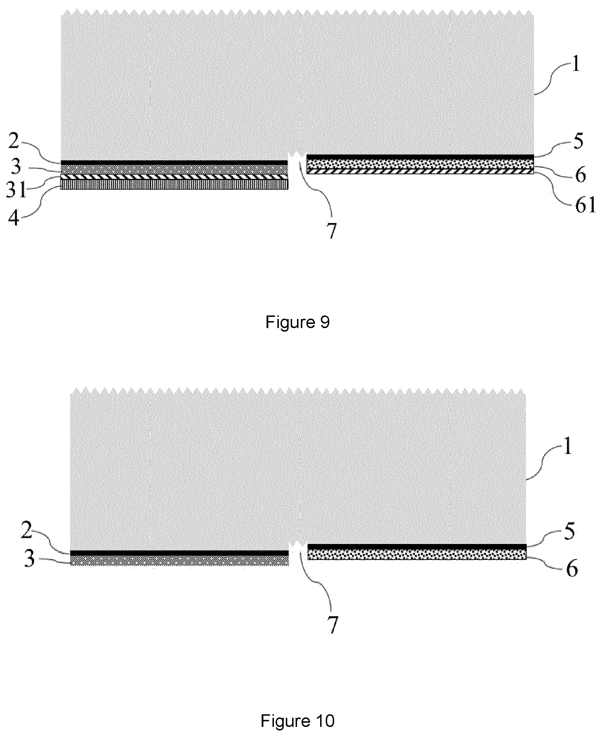

Taking the structure shown in FIG. 8 as an example, the structure shown in FIG. 9 can be obtained through the step S153. As shown in FIG. 9, through this step, the sixth film layer 6' on the front side of the silicon substrate 1 corresponding to the N+ polysilicon layer 6 and the fifth film layer 5' corresponding to the second tunnel oxide layer 5 are removed, and a texture structure is formed on both the gap region 7 and the front side of the silicon substrate 1. This step S153 effectively simplifies the preparation process while achieving selective texturing (texturing in the gap region 7 and on the front side of the silicon substrate 1), thereby reducing interferences of the conditions in the preparation process of the back contact solar cell and meanwhile improving the light utilization rate of the prepared back contact solar cell.

Further, for the structure shown in FIG. 9, the laser blocking layer 4 and the first silicon oxide layer 31 in the second region and the second silicon oxide layer 61 on the N+ polysilicon layer 6 in the first region are removed through the step S16 to form a fully passivated contact structure of a back contact solar cell, thereby obtaining the structure shown in FIG. 10. As can be seen from FIG. 10, in the obtained back contact solar cell, not only the P+ polysilicon layer 3 and the N+ polysilicon layer 6 are isolated by the gap region 7, but also the first tunneling oxide layer 2 corresponding to the P+ polysilicon layer 3 and the second tunneling oxide layer 5 corresponding to the N+ polysilicon layer 6 are isolated by the gap region 7, so as to further reduce carrier recombination, which helps to further improve the photoelectric conversion efficiency of the back contact solar cell.

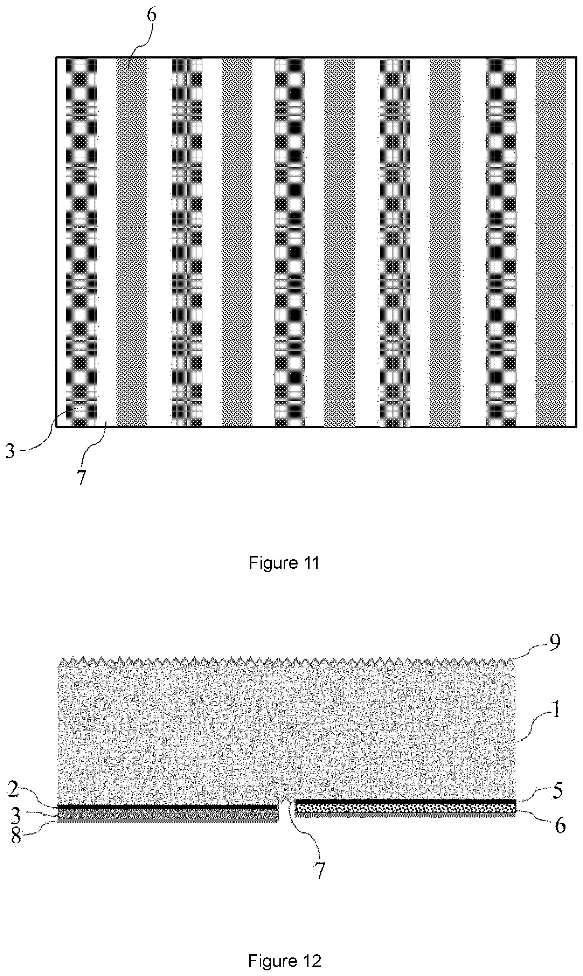

The bottom view of the structure (i.e., a planar structure of the back side of the silicon substrate) of FIG. 10 obtained through the above steps can be shown in FIG. 11. As can be seen from FIG. 11, the P+ polysilicon layer 3 and the N+ polysilicon layer 6 formed on the back side of the silicon substrate are arranged alternately, and there is a gap region 7 between the P+ polysilicon layer 3 and N+ polysilicon layer 6 which are adjacent so as to isolate the P+ polysilicon layer 3 from the N+ polysilicon layer 6.

Further, taking the structure shown in FIG. 10 as an example, after the above step S16, the preparation method may further comprise: forming a back passivation anti-reflection layer 8 in the first region and the second region on the back side of the silicon substrate 1 and forming a front passivation anti-reflection layer 9 on the front side of the silicon substrate 1 to obtain the structure shown in FIG. 12, so as to improve the light absorption performance of the back contact solar cell, wherein the front passivation anti-reflection layer 9 and the back passivation anti-reflection layer 8 can be formed synchronously, and the front passivation anti-reflection layer 9 and the back passivation anti-reflection layer 8 which are formed synchronously can also be prepared by one or more deposition methods selected from LPCVD, PECVD, PVD and ALD. The front passivation anti-reflection layer 9 and the back passivation anti-reflection layer 8 as prepared may both include at least one of aluminum oxide, silicon oxide, gallium oxide, silicon nitride, aluminum nitride, and silicon nitride oxide. By synchronously forming the front passivation anti-reflection layer 9 and the back passivation anti-reflection layer 8, the preparation process of the back contact solar cell is effectively simplified.

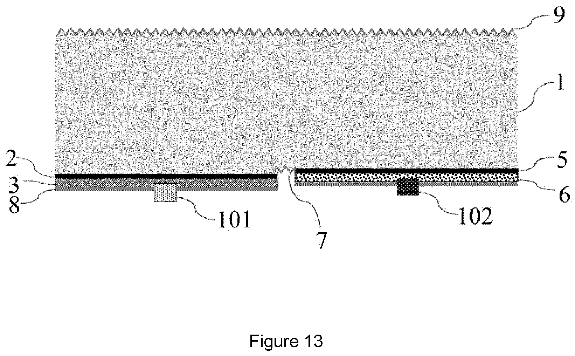

Further, taking the structure shown in FIG12 as an example, after forming the back passivation anti-reflection layer 8 and the front passivation anti-reflection layer 9, the above preparation method may further comprise: preparing a first electrode 101 which penetrates the back passivation anti-reflection layer 8 and is connected to the P+ polysilicon layer 3 and a second electrode 102 which penetrates the back passivation anti-reflection layer 8 and is connected to the N+ polysilicon layer 6, respectively, to obtain the structure shown in FIG. 13, wherein the first electrode 101 and the second electrode 102 may be prepared synchronously, and the first electrode 101 and the second electrode 102 may be prepared by any one of the following methods for preparing a metal electrode.

A first method for preparing a metal electrode: printing a slurry for the first electrode 101 and a slurry for the second electrode 102 respectively in the region where the P+ polysilicon layer 3 is located and the region where the N+ polysilicon layer 6 is located; sintering; and burning the slurry for the first electrode 101 and the slurry for the second electrode 102 through the back passivation anti-reflection layer 8 to contact the P+ polysilicon layer 3 and the N+ polysilicon layer 6, respectively.

A second method for preparing a metal electrode: using laser ablation in the region where the P+ polysilicon layer 3 is located and the region where the N+ polysilicon layer is located; printing a slurry for the first electrode 101 and a slurry for the second electrode 102 respectively and covering the ablation regions; sintering to obtain the first electrode 101 and the second electrode 102.

A third method for preparing a metal electrode: using laser ablation in the region where the P+ polysilicon layer 3 is located and the region where the N+ polysilicon layer is located, and depositing by electroplating to form a first electrode 101 and a second electrode 102.

It is worth noting that FIGs. 2 to 4, FIGs. 6 to 10, FIG. 12 and FIG. 13 as involved in the embodiments of the present disclosure only exemplarily provide partial structures corresponding to the P+ polysilicon layer 3 and N+ polysilicon layer 6 which are adjacent. Based on the partial structures in combination with FIG. 11, those skilled in the art can obtain a complete structure.

In the preparation method for a solar cell as provided in the above respective embodiments, a laser blocking layer is arranged on the P+ polysilicon layer. On the one hand, when the silicon oxide layers in the second region and the gap region are removed by laser, the laser blocking layer present in the second region can absorb laser energy and avoid laser energy from being transferred to the P+ polysilicon layer and the first tunneling oxide layer which need to be retained in the back contact solar cell, so as to avoid the laser treatment in this step from destroying or damaging the P+ polysilicon layer and the first tunneling oxide layer in the second region, and further ensure the integrity of the P+ polysilicon layer and the first tunneling oxide layer in the back contact solar cell and the performance of the cell while contributing to the stability of the preparation process. On the other hand, the laser blocking layer can be caused to absorb laser energy and block the transfer of laser energy in the process of removing the laser blocking layer and the first silicon oxide layer in the first region on the back side of the silicon substrate by laser; moreover, after removing the laser blocking layer in the first region on the back side of the silicon substrate by laser, due to the presence of a step of removing the first tunneling oxide layer and the P+ polysilicon layer in the first region by alkaline solution polishing and the presence of a step of controlling, in the first region on the back side of the silicon substrate, the formation of a second tunneling oxide layer and an N+ polysilicon layer stacked on the second tunneling oxide layer, which are isolated from and alternately arranged with the first tunneling oxide layer and the P+ polysilicon layer, i.e., a step of re-forming a second tunneling oxide layer below the N+ polysilicon layer after the laser treatment, the width of the first region can be controlled more accurately by causing the laser to have a wider use window and removing the laser blocking layer and the first silicon oxide layer in the first region on the back side of the silicon substrate by laser without considering the damage of the laser to the first tunneling oxide layer and the P+ polysilicon layer in the process of laser treatment, which helps to reduce the production cost of the back contact solar cell and facilitates the commercialized promotion of the back contact solar cell.

In addition, based on the above fact that the damage of the laser to the first tunneling oxide layer and the P+ polysilicon layer in the first region does not need to be considered in the process of causing the laser to have a wider use window and removing the laser blocking layer in the first region, the laser blocking layer in the second region is subsequently removed by acid cleaning so that the laser blocking layer will not remain in the final cell structure. Therefore, both the arrangement of the laser blocking layer and the thickness of the laser blocking layer would not have any influence on the back contact solar cell. On this basis, the thickness of the laser blocking layer can be adjusted according to requirements, so that the preparation process of the back contact solar cell has better process flexibility and a better process operation window.

Furthermore, due to the presence of a step of removing the first tunneling oxide layer and the P+ polysilicon layer in the first region by alkaline solution polishing and the presence of a step of controlling, in the first region on the back side of the silicon substrate, the formation of a second tunneling oxide layer and an N+ polysilicon layer stacked on the second tunneling oxide layer, which are isolated from and alternately arranged with the first tunneling oxide layer and the P+ polysilicon layer, i.e., a step of re-forming a second tunneling oxide layer below the N+ polysilicon layer after the laser treatment, then, even if the laser causes damage to a tunneling oxide layer corresponding to the N+ doped polysilicon layer under a wider laser use window, it will not affect the photoelectric conversion performance of the back contact solar cell, which improves the stability of the preparation process of the back contact solar cell and can thereby effectively improve the relative consistency in the photoelectric conversion efficiencies between the prepared back contact solar cells. In addition, removing the first tunneling oxide layer and the P+ polysilicon layer in the first region by alkaline solution polishing can avoid residual P+ doped elements in the first region, thereby reducing carrier recombination in the first region and effectively improving the photoelectric conversion efficiency of the back contact solar cell.

In addition, in the solution provided in the above embodiments, both the region where the first tunneling oxide layer is formed and the region where the second tunneling oxide layer is formed are caused to have polished surfaces through polishing treatment, so as to ensure the flatness and uniformity of the first tunneling oxide layer, the second tunneling oxide layer, the P+ polysilicon layer and the N+ polysilicon layer and effectively improve the passivation effect and photoelectric conversion efficiency of the back contact solar cell.

In addition, texturing of the gap region and the front side is completed in the process of removing the N+ polysilicon and the second silicon oxide layer in the second region and the gap region, so that both the gap region and the front side of the prepared back contact solar cell are texture structures, which simplifies the preparation process and thereby ensures the light utilization rate of the back contact solar cell.

The schematic view and bottom view of a cross-sectional structure of the back contact solar cell obtained by the preparation method as provided in the above respective embodiments may be shown in FIG. 10 and FIG. 11, respectively.

As shown in FIGs. 10 and 11, the back contact solar cell may comprise:
a silicon substrate 1;
a first tunneling oxide layer 2 and a second tunneling oxide layer 5 which are formed on a back side of the silicon substrate 1, isolated from each other and arranged alternately;
a P+ polysilicon layer 3 stacked on the first tunneling oxide layer 2;
an N+ polysilicon layer 6 stacked on the second tunneling oxide layer 5;
a gap region 7 which is formed on the back side of the silicon substrate 1 and used to isolate the first tunneling oxide layer 2 and the second tunneling oxide layer 5 which are adjacent and the P+ polysilicon layer 3 and N+ polysilicon layer 6 which are adjacent; wherein
regions on the back side of the silicon substrate 1 corresponding to the first tunneling oxide layer 2 and the second tunneling oxide layer 5 are polished surfaces; the front side of the silicon substrate 1 and the gap region 7 are provided with texture structures which are synchronously formed, wherein the texture structures are synchronously formed in a process of controlling the formation of the second tunneling oxide layer 5 and the N+ polysilicon layer 6 which are isolated from and alternately arranged with the first tunneling oxide layer 2 and the P+ polysilicon layer 3;
wherein the silicon substrate 1 may be a P-type silicon substrate or an N-type silicon substrate.

By configuring the regions on the back side of the silicon substrate 1 corresponding to the first tunneling oxide layer 2 and the second tunneling oxide layer 5 as polished surfaces, it is possible to ensure the integrity and uniformity of the first tunneling oxide layer 2 and the second tunneling oxide layer 5, so as to effectively realize a fully passivated contact structure.

In addition, the texture structures synchronously formed on the front side of the silicon substrate 1 and on the gap region 7 are formed synchronously in the process of controlling the formation of the second tunneling oxide layer 5 and the N+ polysilicon layer 6 which are isolated from and arranged alternately with the first tunneling oxide layer 2 and the P+ polysilicon layer 3, which simplifies the preparation process of the back contact solar cell and facilitates the commercialized promotion of the back contact solar cell.

Further, the texture structures provided on the front side of the silicon substrate 1 and on the gap region 7 are formed in the process of removing the N+ polysilicon layer 6 and the second tunneling oxide layer 5 formed on the second region 6 and the gap region 7 by using an alkaline solution, which effectively simplifies the above process of a back contact solar cell.

In addition, the texture structure can effectively improve the light utilization efficiency of the back contact solar cell.

Further, in order to effectively reduce the carrier recombination of the back contact solar cell and improve the isolation effect of the back contact solar cell, not only the P+ polysilicon layer 3 and the N+ polysilicon layer 6 but also the first tunneling oxide layer 2 and the second tunneling oxide layer 5 are isolated by a gap region 7. The width of the gap region 7 or the spacing between the P+ polysilicon layer 3 and the N+ polysilicon layer 6 which are adjacent is generally 1×10³ nm to 5×10⁵ nm, wherein the spacing between the P+ polysilicon layer 3 and the N+ polysilicon layer 6 which are adjacent refers to a distance between a side of the P+ polysilicon layer 3 close to the N+ polysilicon layer 6 and a side of the N+ polysilicon layer 6 close to the P+ polysilicon layer 3. By controlling the width of the gap region 7 or the spacing between the P+ polysilicon layer 3 and the N+ polysilicon layer 6 which are adjacent to any value between 1×10³ nm and 5×10⁵ nm, such as 2×10³ nm, 3×10³ nm, 5×10³ nm, 1×10⁴ nm, 3×10⁴ nm, 5×10⁴ nm, 7×10⁴ nm, 9×10⁴ nm, 1×10⁵ nm, 2×10⁵ nm, 4×10⁵ nm, 5×10⁵ nm, etc., it is possible to ensure the P+ polysilicon layer 3 and the N+ polysilicon layer 6 while effectively reducing carrier recombination.

The thickness of the first tunneling oxide layer 2 may be 0.5 nm to 3.0 nm.

In addition, the thickness of the second tunneling oxide layer 5 is 0.5 nm to 3.0 nm.

In addition, as shown in FIG. 12, the above back contact solar cell may further comprise: a back passivation anti-reflection layer 8 stacked and formed on the P+ polysilicon layer 3, the N+ polysilicon layer 6 and the gap region 7 on the back side of the silicon substrate 1, and a front passivation anti-reflection layer 9 formed on the front side of the silicon substrate 1, so as to effectively improve the light absorption effect of the back contact solar cell.

Further, as shown in FIG. 13 , the above back contact solar cell may further comprise: a first electrode 101 which penetrates the back passivation anti-reflection layer 8 and is connected to the P+ polysilicon layer 3, and a second electrode 102 which penetrates the back passivation anti-reflection layer 8 and is connected to the N+ polysilicon layer 6.

The embodiments of the present disclosure also provide a photovoltaic component, which may comprise: a cell sheet made of the back contact solar cell in the above embodiments.

The embodiments of the present disclosure also provide a power station, which may comprise: the photovoltaic component provided in the above embodiments.

The above preparation method will be described in details below by two specific embodiments.

### Embodiment 1:

step A1: performing double-sided polishing treatment on a P-type silicon substrate;
step B1: using the atomic deposition technology, at a deposition temperature of 100°C to 500°C, depositing a first layer of a silicon dioxide tunneling oxide layer with a thickness of 1 nm on one main surface of the P-type silicon substrate (the main surface is a back side of the silicon substrate), and depositing a first film layer on the other main surface of the P-type silicon substrate (the other main surface is a front side of the silicon substrate) corresponding to the first layer of the silicon dioxide tunneling oxide layer, the thickness of the first film layer being generally smaller than the thickness of the first layer of the silicon dioxide tunneling oxide layer;
step C1: growing an intrinsic amorphous silicon layer on the first layer of the silicon dioxide tunneling oxide layer using a LPCVD (Low Pressure Chemical Vapor Deposition) equipment; then implanting a boron element into the intrinsic amorphous silicon layer using an ion implantation equipment, performing high temperature annealing, wherein the annealing temperature is 800-950°C and the amorphous silicon layer implanted with the boron element forms a 100-200 nm P+ polysilicon layer after annealing, synchronously forming a first silicon oxide layer on the P+ polysilicon layer, and synchronously forming a second film layer on the first film layer corresponding to the P+ polysilicon layer and a third film layer corresponding to the first silicon oxide layer;
step D1: depositing a laser blocking layer with a thickness of 2×10⁵ nm on the first silicon oxide layer by PVD, and synchronously forming a fourth film layer on the third film layer corresponding to the laser blocking layer;
step E1: removing the fourth film layer and the third film layer on the front side of the silicon substrate by acid etching;
step F1: removing the laser blocking layer and the first silicon oxide layer in the first region on the back side of the silicon substrate by laser, wherein the first region and the second region retaining the laser blocking layer and the first silicon oxide layer are arranged alternately;
step G1: removing the first tunneling oxide layer and the P+ polysilicon layer in the first region and the corresponding second film layer and first film layer on the front side of the silicon substrate by alkaline solution polishing, and synchronously removing a portion of the silicon substrate in the first region;
step H1: using the atomic deposition technology, at a deposition temperature of 100°C to 500°C, depositing a second layer of a silicon dioxide tunneling oxide layer with a thickness of 1.5nm on the silicon substrate in the first region and the laser blocking layer in the second region, and depositing a fifth film layer on the other main surface of the P-type silicon substrate (the other main surface is a front side of the silicon substrate) corresponding to the second layer of the silicon dioxide tunneling oxide layer, the thickness of the fifth film layer being generally smaller than the thickness of the second layer of the silicon dioxide tunneling oxide layer;
Step I1: growing an intrinsic amorphous silicon layer on the second layer of the silicon dioxide tunneling oxide layer using a LPCVD (Low Pressure Chemical Vapor Deposition) equipment; then implanting a phosphorus element into the intrinsic amorphous silicon layer using an ion implantation equipment, performing high-temperature annealing, wherein the amorphous silicon layer implanted with the phosphorus element forms a 100-200 nm N+ polysilicon layer after annealing, synchronously forming a second silicon oxide layer on the N+ polysilicon layer, and synchronously forming a sixth film layer on the fifth film layer corresponding to the N+ polysilicon layer and a seventh film layer corresponding to the second silicon oxide layer;
step J1: laser removing the seventh film layer on the front side of the silicon substrate, and the second silicon oxide layer in the second region and the gap region in the first region adjacent to the second region;
step K1: removing the N+ polysilicon layer and the second tunneling oxide layer in the second region and the gap region, the second silicon oxide layer on the N+ polysilicon layer, and the sixth film layer and the fifth film layer on the front side of the silicon substrate by an alkaline solution, and synchronously forming a texture structure on the gap region and the front side of the silicon substrate;
step L1: depositing a back passivation anti-reflection layer in the first region and the second region on the back side of the silicon substrate, and synchronously depositing a front passivation anti-reflection layer on the front side of the silicon substrate;
step M1: printing a slurry for a first electrode and a slurry for a second electrode respectively in the region where the P+ polysilicon layer is located and the region where the N+ polysilicon layer is located, sintering, and burning the slurry for the first electrode and the slurry for the second electrode through the back passivation anti-reflection layer to be in contact with the P+ polysilicon layer and the N+ polysilicon layer, respectively.

### Embodiment 2:

step A2: performing double-sided polishing treatment on an N-type silicon substrate;
step B2: depositing, using a LPCVD equipment, a first layer of a silicon dioxide tunneling oxide layer with a thickness of 2.5nm on one main surface of the P-type silicon substrate (the main surface is a back side of the silicon substrate), and depositing a first film layer on the other main surface of the P-type silicon substrate (the other main surface is a front side of the silicon substrate) corresponding to the first layer of the silicon dioxide tunneling oxide layer, the thickness of the first film layer being generally smaller than the thickness of the first layer of the silicon dioxide tunneling oxide layer;
step C2: growing an intrinsic amorphous silicon layer on the first layer of the silicon dioxide tunneling oxide layer using a LPCVD equipment; then implanting a boron element into the intrinsic amorphous silicon layer using an ion implantation equipment, performing high-temperature annealing, wherein the annealing temperature is 800-950°C and the amorphous silicon layer implanted with the boron element forms a 100-200 nm P+ polysilicon layer after annealing, synchronously forming a first silicon oxide layer on the P+ polysilicon layer, and synchronously forming a second film layer on the first film layer corresponding to the P+ polysilicon layer and a third film layer corresponding to the first silicon oxide layer;
step D2: depositing a laser blocking layer with a thickness of 1×10⁴ nm on the first silicon oxide layer by a PECVD equipment, and synchronously forming a fourth film layer on the third film layer corresponding to the laser blocking layer;
step E2: removing the fourth film layer and the third film layer on the front side of the silicon substrate by acid etching;
step F2: removing the laser blocking layer and the first silicon oxide layer in the first region on the back side of the silicon substrate by laser, wherein the first region and the second region retaining the laser blocking layer and the first silicon oxide layer are arranged alternately;
step G2: removing the first tunneling oxide layer and the P+ polysilicon layer in the first region and the corresponding second film layer and first film layer on the front side of the silicon substrate by alkaline solution polishing, and synchronously removing a portion of the silicon substrate in the first region;
step H2: depositing, using a PECVD equipment, a second layer of a silicon dioxide tunneling oxide layer with a thickness of 2 nm on the silicon substrate in the first region and the laser blocking layer in the second region, and depositing a fifth film layer on the other main surface of the P-type silicon substrate (the other main surface is a front side of the silicon substrate) corresponding to the second layer of the silicon dioxide tunneling oxide layer, the thickness of the fifth film layer being generally smaller than the thickness of the second layer of the silicon dioxide tunneling oxide layer;
step I2: growing an intrinsic amorphous silicon layer on the second layer of the silicon dioxide tunneling oxide layer using a PECVD equipment; then implanting a phosphorus element into the intrinsic amorphous silicon layer using an ion implantation equipment, performing high-temperature annealing, wherein the amorphous silicon layer implanted with the phosphorus element forms a 100-200 nm N+ polysilicon layer after annealing, synchronously forming a second silicon oxide layer on the N+ polysilicon layer, and synchronously forming on the fifth film layer a sixth film layer corresponding to the N+ polysilicon layer and a seventh film layer corresponding to the second silicon oxide layer;
step J2: laser removing the seventh film layer on the front side of the silicon substrate, and the second silicon oxide layer in the second region and the gap region in the first region adjacent to the second region;
step K2: removing the N+ polysilicon layer and the second tunneling oxide layer in the second region and the gap region, the second silicon oxide layer on the N+ polysilicon layer, and the sixth film layer and the fifth film layer on the front side of the silicon substrate by an alkaline solution, and synchronously forming a texture structure on the gap region and the front side of the silicon substrate;
step L2: depositing a back passivation anti-reflection layer in the first region and the second region on the back side of the silicon substrate, and synchronously depositing a front passivation anti-reflection layer on the front side of the silicon substrate;
step M2: using laser ablation in the region where the P+ polysilicon layer is located and the region where the N+ polysilicon layer is located, printing a slurry for a first electrode and a slurry for a second electrode respectively and covering the ablation regions; sintering to obtain the first electrode and the second electrode.

The introductions provided for the above steps are only used to help understand the method, structure and core concept of the present disclosure. For those of ordinary skill in the art, they can make several improvements and modifications to the present disclosure without departing from the principles of the present disclosure, and these improvements and modifications also fall within the protection scopes of the claims of the present disclosure.

## Claims

1. A preparation method for a back contact solar cell, comprising:
step a: performing double-sided polishing treatment on a silicon substrate (1);
step b: stacking and forming a first tunneling oxide layer (2), a P+ polysilicon layer (3) and a laser blocking layer (4) on a back side of the silicon substrate (1) from inside to outside, wherein in a process of forming the P+ polysilicon layer (3), a first silicon oxide layer (31) is synchronously formed on the P+ polysilicon layer (3);
step c: removing the laser blocking layer (4) and the first silicon oxide layer (31) in a first region on the back side of the silicon substrate (1) by laser, wherein the first region and a second region retaining the laser blocking layer (4) and the first silicon oxide layer (31) are arranged alternately;
step d: removing the first tunneling oxide layer (2) and the P+ polysilicon layer (3) in the first region by alkaline solution polishing;
step e: controlling, in the first region on the back side of the silicon substrate (1), the formation of a second tunneling oxide layer (5) and an N+ polysilicon layer (6) stacked on the second tunneling oxide layer (5), which are isolated from and alternately arranged with the first tunneling oxide layer (2) and the P+ polysilicon layer (3), and synchronously performing texturing treatment on a gap region (7) in the first region adjacent to the second region and on a front side of the silicon substrate (1) so as to form a texture structure on the gap region (7) and the front side of the silicon substrate, wherein the gap region (7) is used to isolate the P+ polysilicon layer (3) and the N+ polysilicon layer (6) which are adjacent;
step f: removing the laser blocking layer (4) and the first silicon oxide layer (31) on the second region by acid cleaning.

2. The preparation method for a back contact solar cell according to claim 1, **characterized in that**
for a circumstance where a plurality of film layers are synchronously formed correspondingly on a front side of the silicon substrate (1) in the process of forming the first tunneling oxide layer (2), the P+ polysilicon layer (3), the first silicon oxide layer (131) and the laser blocking layer (4) in the step b,
after the step b, further comprises:
step c': removing the film layers on the front side of the silicon substrate (1) corresponding to the first silicon oxide layer (31) and the laser blocking layer (4) by acid etching or laser.

3. The preparation method for a back contact solar cell according to claim 2, **characterized by** comprising:
in the alkaline solution polishing of the step d, synchronously removing the film layers on the front side of the silicon substrate (1) corresponding to the first tunneling oxide layer (2) and the P+ polysilicon layer (3).

4. The preparation method for a back contact solar cell according to any of claims 1 to 3, **characterized in that** the step e comprises:
step e1: synchronously forming a second tunneling oxide layer (5) and an N+ polysilicon layer (6) in the first region and the second region on the back side of the silicon substrate (1), wherein in a process of forming the N+ polysilicon layer (6), a second silicon oxide layer (61) is synchronously formed on the N+ polysilicon layer (6);
step e2: laser removing the second silicon oxide layer (61) in the second region and the gap region (7) in the first region adjacent to the second region;
step e3: removing the N+ polysilicon layer (6) and the second tunneling oxide layer (5) in the second region and the gap region (7) by the alkaline solution, while forming a texture structure on the gap region (7) and the front side of the silicon substrate (1).

5. The preparation method for a back contact solar cell according to claim 4, **characterized in that**
for a circumstance where a plurality of film layers are synchronously formed correspondingly on the front side of the silicon substrate (1) in the process of forming the second tunneling oxide layer (5), the N+ polysilicon layer (6) and the second silicon oxide layer (61) in the step e1, after the step e1, the preparation method for a back contact solar cell further comprises: step e2': removing a film layer on the front side of the silicon substrate (1) corresponding to the second silicon oxide layer (61) by acid etching or laser;
and/or
the preparation method for a back contact solar cell further comprises: in the acid cleaning process of the step f, synchronously removing the second silicon oxide layer (61) on the N+ polysilicon layer (6) in the first region.

6. The preparation method for a back contact solar cell according to claim 5, **characterized by** comprising:
in the process of treating by the alkaline solution in the step e3, synchronously removing the film layers on the front side of the silicon substrate (1) corresponding to the second tunneling oxide layer (5) and the N+ polysilicon layer (6).

7. The preparation method for a back contact solar cell according to claim 1 or 5, **characterized by**
after the step f, further comprising:
step g: forming a back passivation anti-reflection layer (8) in the first region and the second region on the back side of the silicon substrate (1), and forming a front passivation anti-reflection layer (9) on the front side of the silicon substrate (1).

8. The preparation method for a back contact solar cell according to claim 7, **characterized by**, after the step g, further comprising:
step h: preparing a first electrode (101) which penetrates the back passivation anti-reflection layer (8) and is connected to the P+ polysilicon layer (3) and a second electrode (102) which penetrates the back passivation anti-reflection layer (8) and is connected to the N+ polysilicon layer (6), respectively.

9. The preparation method for a back contact solar cell according to claim 1, **characterized in that**:
the thickness of the first tunneling oxide layer (2) is 0.5 nm to 3.0 nm;
and/or
the thickness of the second tunneling oxide layer (5) is 0.5 nm to 3.0 nm.

10. The preparation method for a back contact solar cell according to claim 1,
the step e further comprises: controlling the width of the gap region 7 or the spacing between the P+ polysilicon layer 3 and the N+ polysilicon layer 6 which are adjacent to be 1×10³ nm to 5×10⁵ nm.

11. The preparation method for a back contact solar cell according to claim 1, the laser blocking layer 4 is deposited from at least one of the following materials:
silicon oxide, silicon nitride oxide and silicon nitride.

12. A back contact solar cell prepared by the preparation method according to any of claims 1 to 11, **characterized by** comprising:
a silicon substrate (1);
a first tunneling oxide layer (2) and a second tunneling oxide layer (5) which are formed on a back side of the silicon substrate (1), isolated from each other and arranged alternately;
a P+ polysilicon layer (3) stacked on the first tunneling oxide layer (2);
an N+ polysilicon layer (6) stacked on the second tunneling oxide layer (5);
a gap region (7) which is formed on the back side of the silicon substrate (1) and used to isolate the first tunneling oxide layer (2) and the second tunneling oxide layer (5) which are adjacent and the P+ polysilicon layer (3) and N+ polysilicon layer (6) which are adjacent; wherein
the regions on the back side of the silicon substrate (1) corresponding to the first tunneling oxide layer (2) and the second tunneling oxide layer (5) are polished surfaces;
the front side of the silicon substrate (1) and the gap region (7) are provided with texture structures which are synchronously formed, wherein the texture structures are synchronously formed in a process of controlling the formation of the second tunneling oxide layer (5) and the N+ polysilicon layer (6) which are isolated from and alternately arranged with the first tunneling oxide layer (2) and the P+ polysilicon layer (3).

13. The back contact solar cell according to claim 12,
the texture structures arranged on the front side of the silicon substrate (1) and on the gap region (7) are formed in the process of removing, by an alkaline solution, the N+ polysilicon layer 6 and the second tunneling oxide layer 5 formed on the gap region 7.

14. The back contact solar cell according to claim 12 or 13,
the width of the gap region 7 or the spacing between the P+ polysilicon layer 3 and the N+ polysilicon layer 6 which are adjacent is 1×10³ nm to 5×10⁵ nm;
and/or
the thickness of the first tunneling oxide layer 2 is 0.5 nm to 3.0 nm;
and/or
the thickness of the second tunneling oxide layer 5 is 0.5nm to 3.0nm.
